# EUROPEAN PATENT APPLICATION

(11) **EP 0 989 604 A2**
(43) Date of publication of application: **29.03.2000**
(21) Application number: 99650086.4
(22) Date of filing: 21.09.1999
(51) Int. Cl.: H01L 21/8249, H01L 21/28, H01L 21/285

(54) **In situ deposition of gate oxide and amorphous silicon electrode and corresponding structure**

(30) Priority: 22.09.1998 US 158256
(71) Applicant: Fairchild Semiconductor Corporation, South Portland, Maine 04106 (US)
(72) Inventor: Carbone, Thomas A., Gorham, Maine 04038 (US)
(74) Representative: McCarthy, Denis Alexis

(57) **Abstract**

A method of forming an intermediate semiconductor structure as part of a BiCMOS process that includes the fabrication of a split polysilicon layer. The intermediate structure includes a gate oxide layer (20) and a protective amorphous silicon layer (21) formed on the surface of the gate oxide layer in an in situ process. The protective amorphous structure is formed to protect the integrity of the gate oxide layer during subsequent acid washes associated with the BiCMOS process. The amorphous layer may be deposited in a thickness substantially less than that associated with prior split polycrystalline silicon processes. After acid washing is completed the amorphous layer is converted into a polysilicon layer (28) in subsequent polycrystalline silicon layer stages. The process associated with the in situ formation of the oxide and amorphous layers is substantially less than prior independent processing and results in lower yield losses.

## Description

### Background Of The Invention

### 1. Field of the Invention.

The present invention relates to methods of fabricating semiconductor devices. In particular, the present invention relates to the steps associated with the fabrication of Bipolar Complementary Metal Oxide Semiconductor (BiCMOS) structures. More particularly, the present invention relates to those aspects of the fabrication of BiCMOS structures involving the formation of the insulative oxide layer under the gates of the MOS transistors and the gates themselves. The present invention provides for fabrication of those disparate components within the same vertical tube batch reactor and without subsequent harmful effect on the remainder of the BiCMOS fabrication steps.

### 2. Description of the Prior Art.

In an effort to create increasingly faster semiconductor devices that consume less power, it is a goal in the semiconductor industry to create increasingly smaller integrated circuit (IC) devices. To that end, the steps associated with the fabrication of IC devices are becoming more critical and complex. With increasing complexity and criticality comes significant potential for a decrease in productivity, including greater fabrication costs and lower device yield. It is therefore a continuing goal in this field to minimize fabrication steps and the time and errors associated therewith.

Improvements are sought in all areas of semiconductor fabrication, particularly so in advanced processes. In the field of advanced BiCMOS devices, the integration of the steps associated with the formation of bipolar devices and MOS devices creates the type of complexity that requires considerable fabrication coordination. The addition of more masks, implants, depositions, etchings, and the like for advanced BiCMOS processing increases the costs associated with raw materials, capital equipment, and direct and indirect labor obligations.

One area in particular in which more steps may be particularly costly is that of the thermal processing of semiconductor wafers. It has been determined that the cycle times required to grow various of the insulative and conductive layers of integrated circuitry form a significant part of the fabrication time frame. Efforts to reduce the thermal processing steps have been made; however, effects on wafer yield and circuit integrity must be carefully considered.

In general terms, there are approximately 18 significant processing or mask steps associated with one form of fabrication processing of BiCMOS devices. Those steps, identified by the mask designations noted, are substantially as follows:

| Mask No. | Mask Function |
|---|---|
| 1.0 | Buried Collector Layer Mask |
| 2.0 | Retrograde NWell Definition Mask |
| 3.0 | Retrograde PWell/Channel Stop Definition Mask |
| 4.0 | Isolation Oxide Definition Mask |
| 5.0 | Sink Implant & Isolation Oxide Gettering Mask |
| 6.0 | CMOS Active Area and Collector-Base Spacer Def. Mask |
| 7.0 | Active Strip Mask |
| 8.0 | Polycrystalline silicon Gate Definition Mask |
| 9.0 | N LDD Mask |
| 10.0 | P LDD Mask |
| 11.0 | Base Definition Mask |
| 12.0 | Collector, Base, and Emitter Contact Definition Mask |
| 13.0 | Silicide Exclusion Mask |
| 14.0 | P⁺ Source/Drain Definition Mask (PMOS) |
| 15.0 | N⁺ Source/Drain Definition Mask (NMOS) |
| 16.0 | CMOS Contact Definition Mask |
| 17.0 | METAL 1 (M1) Definition Mask |
| 18.0 | METAL 2 (M2) Definition Mask |

Of course, each one of the noted steps includes a plurality of sub-steps, some more so than others.

While there are many steps and stages associated with the complete fabrication of an integrated circuit on a semiconductor wafer, the ones set out above and described briefly herein are directly applicable to the present invention. Of particular interest in regard to the present invention are the steps related to formation of an insulative gate oxide and a protective first gate electrode. Prior to addressing important aspects of the formation of those two areas of a BiCMOS device, the fabrication process will be described briefly in relation to the noted mask steps.

Initially, for a BiCMOS device including an NPN bipolar transistor, a buried collector layer is created on a P type substrate of semiconductor material using conventional fabrication sequences. This is accomplished by introducing, such as by implantation, an N concentration of relatively slow diffusing N type atoms to form an underlying layer for subsequent retrograde diffusion. Next, an "NWell" and a "PWell" are created on the P type substrate of semiconductor material, using conventional fabrication sequences. This is accomplished by introducing, such as by implantation, respectively, an N concentration of relatively fast-diffusing N type atoms to form an NWell "bed" for the PMOS structure, and a P concentration of relatively fast-diffusing P type atoms to form a PWell "bed" for the NMOS structure. Additionally, the P type atoms are introduced into area adjacent to the buried collector layer and the NWell bed to form channel stops for isolation of adjacent active areas. The channel stops isolate the wells from parasitic MOS effects caused by adjacent structures.

After NWell and PWell bed introduction into the substrate, an epitaxial layer in the form of single crystal N type semiconductor material in an N⁻ concentration is formed over the buried collector layer and both well beds. Subsequent conventional diffusion processing drives the NWell and PWell atoms in retrograde concentrations to the surface of the epitaxial layer. The slower diffusing collector layer atoms move toward that surface but do not reach it. Next, isolation oxide layers are formed about the transistor structures by conventional mask, etch, and formation sequences so as to isolate them from adjacent structures. Field oxide regions are formed above the isolation regions to aid in the isolation of adjacent structures at the surface of the epitaxial layer. A collector sink of relatively fast-diffusing N type atoms is then introduced into the epitaxial layer above a portion of the buried collector layer for subsequent collector development.

Continuing with the summary description of one BiCMOS process, formation of the MOS transistor structures requires the fabrication of the gate, source, and drain components of the NMOS and PMOS transistor structures. Additionally, formation of the bipolar transistor structures requires the fabrication of the base, emitter and collector components. For the MOS structures, the gates are formed of a polycrystalline layer of semiconductor material, using a well-known mask, etch, and deposition sequence. This "polysilicon layer" is formed on the surface of the respective wells, but is separated from the well surfaces by an underlying gate oxide layer. In the BiCMOS process, the polysilicon layer is used to form polycrystalline silicon gates of the MOS transistors and a polysilicon emitter of the bipolar transistor upon suitable subsequent implanting. The gate oxide layer acts as a dielectric, insulating the gate of the particular MOS transistor structure from the source, the drain, and the channel lying therebetween. The integrity of this gate oxide layer must be maintained throughout the integrated fabrication process so as to ensure effective transistor operation.

In order to accommodate the different characteristics of the two types of transistors without degrading the quality of either, it has been determined that there are advantages in creating the polysilicon layer in two separate steps. This "split poly" process involves the introduction of a relatively thin layer of polycrystalline silicon over the gate oxide layer in a blanket deposition. Subsequent processing steps are used to dope underneath the first polycrystalline silicon layer in the channel region for PMOS and NMOS threshold voltage development and for anti-punch through protection. On the bipolar side, relatively slow diffusing P type atoms in a P+ concentration are implanted into the surface of the epitaxial layer through the first polycrystalline silicon layer while the collector sink and CMOS active areas are protected by photoresist. It is important to note that the thickness of the first polycrystalline silicon layer must be well defined for purposes of the base implant. That is, if it is too thick the implant may not be driven deep enough to ensure desirable bipolar transistor characteristics.

After the base implant, the first polycrystalline silicon layer and the gate oxide layer are etched away on the surface of the base region only. The remaining active areas are again protected by photoresist. The next phase of the process involves the preparation of the wafer for development of the emitter and collector of the bipolar transistor structure and the gates, and source and drains of the CMOS transistor structures. Prior to undertaking the steps associated with that formation, the entirety of the surface of the first polysilicon layer is pre-cleaned with an acidic compound, generally hydrofluoric acid (HF). A second polysilicon layer is then deposited on the cleaned surface of the first layer. The second polycrystalline silicon layer is substantially thicker than the first. The combination of the two polycrystalline silicon layers creates the pre-cursors for the gates of the CMOS transistor structures and the emitter of the bipolar transistor structure. That is, the two layers are electrode materials. Subsequent well-known steps are used to complete the remainder of the integrated circuitry.

The processing steps particularly related to the formation of the gate oxide layer and the first polysilicon layer include a substantial amount of time in a reactor furnace. As noted earlier, the thermal-growth stages of the BiCMOS process are critical and time consuming. Two areas of processing involving the use of thermal growth include the formation of the gate oxide layer and the polycrystalline silicon electrode layer. These particular processing stages, as with most others, require considerable quality control and coordination.

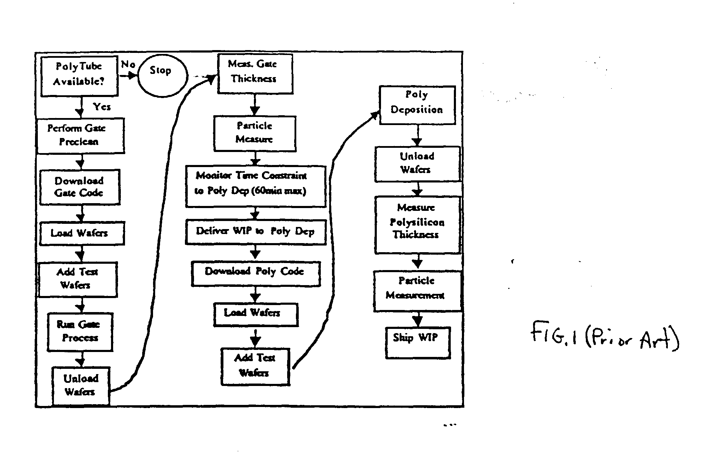

The details of the steps associated with one particular split-poly BiCMOS fabrication process used by Fairchild Semiconductor Corporation of South Portland, Maine, for the development of the prior gate oxide and first polycrystalline silicon layer formation are illustrated in FIG. 1. Under that particular process, there are 19 sub-steps associated with the formation of just those two layers. It is to be noted that other BiCMOS processes may require more or fewer sub-steps related to the formation of the gate oxide and the first polycrystalline silicon layer than those set out in FIG. 1. However, each of the various prior-art BiCMOS processes involves separate processing for the oxide layer and the first polycrystalline silicon layer.

Continuing with the discussion of FIG. 1 for a particular one of those fabrication approaches, it is to be noted that, first and foremost, the two layers must be formed in a substantially continuous process. That is, the polycrystalline silicon layer must be deposited immediately after formation of the gate oxide layer. As a result, the fabrication coordinator must ensure that a polycrystalline silicon layer reactor is available at the point in time in the future when the oxide fabrication is complete. Assuming that is the case, the polycrystalline silicon reactor must necessarily remain idle―non-productive―while it awaits the arrival of the wafer in process (WIP) from the oxide formation stage.

Standard pre-cleaning of the epitaxial layer for subsequent oxide growth is first performed outside of the oxide reactor. The reactor is programmed for the necessary processing parameters, and the wafers in process as well as test wafers used for subsequent measurement of the oxide formation, are then loaded into the oxide reactor. The gate oxide layer is then grown in an atmosphere of oxygen at a processing temperature on the order of 900°C. The wafers are removed from the oxide reactor and measured for thickness and particle levels. As noted earlier, in order to ensure oxide integrity, it is important to ensure that the WIP moves from the oxide reactor to the polycrystalline silicon deposition reactor within a restricted period of time. Although the particular time may vary for other BiCMOS processes, it has been determined that the delay should be no more than about 60 minutes.

It has been determined that the oxide growth steps take about six hours from the start of gate pre-clean to the insertion of the WIP into the polycrystalline silicon reactor. The steps associated with the polycrystalline silicon deposition are shown in FIG. 1. In the prior art, the first polycrystalline semiconductor layer in the split polycrystalline silicon process is formed using a chemical vapor deposition (CVD) at about 600°-625°C. The polycrystalline silicon is grown to a thickness of about 50 nanometers (nm) over a period of about two hours.

It has been determined that this first polycrystalline silicon layer must be at least that thick in order to ensure that the subsequent HF chemical oxide surface cleaning of the first polycrystalline silicon layer will not be problematic. It is known that the HF can migrate through interstices associated with the molecular orientation of the polycrystalline silicon. If permitted to move through to the gate oxide layer, the HF causes considerable damage to the insulative characteristics of that layer. While it is preferable to have a thin first polycrystalline silicon layer for purposes of subsequent base implantation and etching, the obligation to restrict HF migration requires formation of the thicker layer. Therefore, the need to protect the gate oxide layer results in the obligation to take the time indicated to form the first polycrystalline silicon layer of a certain minimum thickness. The thickness of that polycrystalline silicon layer also drives the requirements associated with the base implant and etching steps. It would be advantageous to reduce the thickness of the first polycrystalline silicon layer without compromising gate oxide layer protection during subsequent BiCMOS fabrication steps.

Given the number of steps and the importance of those steps required in the formation of the gate oxide and the first of the split polycrystalline silicon layers, it can be seen that considerable time and considerable likelihood of yield loss is involved. The extent of time and yield loss potential clearly varies from one particular BiCMOS process to another. In general regarding attempts throughout the semiconductor fabrication industry to increase productivity, efforts have recently been made to combine processing steps in order to reduce time and wafer yield loss. This has been accomplished through the development of new reactors. In particular, cluster tools have been used to maintain the WIP within a clean environment, moving it from one satellite location therein to another. Such processing has been deemed applicable to the formation of the gate oxide layer and the first polysilicon layer. However, there is still an issue of processing through time per wafer in the cluster tool arrangement. That is, clustering may be effective in reducing contamination but it does not provide similar reductions in processing times.

Another technique recently developed in an effort to cut down processing time has been the introduction of chained implants. Under this process, ion implantation is carried out at varied energy levels to control ion concentration levels at different depths. To that end, a single thermal operation may produce the desired doping distribution throughout the silicon. Unfortunately, this approach requires expensive specialized implanters that require capital expenditures that may offset any productivity gains associated with shortened thermal processing cycles.

It is important to note that single wafer processing, such as that provided in rapid temperature operations (RTO) or rapid temperature processing (RTP), can also lead to the reduction of yield loss associated with the fabrication process. That includes the loss associated with the formation of the gate oxide and the electrode material that is the first of the split polycrystalline silicon layers of the prior art. Obviously, this is due to the significance of the loss of a single wafer in one process cycle, versus the number of single wafers that may be successfully produced over the course of a day for example. However, the overall through time associated with RTP fabrication for a given quantity of wafers over a specified production time period may be significantly greater than that associated with the batch reacting of hundreds of wafers in one processing cycle. Therefore, it would be more advantageous to improve the batch reaction process to reduce yield loss and to reduce processing time if possible.

Therefore, what is needed is an improved BiCMOS fabrication process that includes a reduction in yield loss and a reduction in through time. What is also needed is such an improved BiCMOS fabrication process that involves the use of vertical batch reactors in the formation of the gate oxide layer and the split polycrystalline silicon layers. Further, what is needed is such an improved BiCMOS fabrication process that creates a new structure including a thinner first polycrystalline silicon layer having the capability to provide suitable protection to the integrity of the gate oxide layer. Yet further, what is needed is a reduction in the number of steps used to form the gate oxide layer and at least the first layer of the split polycrystalline silicon deposition.

### Summary Of The Invention

It is an object of the present invention to provide an improved BiCMOS fabrication process that includes a reduction in yield loss and a reduction in through time. It is also an object of the present invention to provide an improved BiCMOS fabrication process that involves the use of vertical batch reactors in the formation of the gate oxide layer and the split polycrystalline silicon layers. It is a further object of the present invention to provide an improved BiCMOS fabrication process that creates a new structure including a thinner first polycrystalline silicon layer having the capability to provide suitable protection to the integrity of the gate oxide layer. Yet further, it is an object of the present invention to reduce the number of steps associated with the formation of the gate oxide layer and at least the first layer of the electrode material deposition.

These and other objectives are achieved in the present invention through a novel fabrication process that creates a new wafer-in-process structure. The fabrication process involves the in situ deposition of both the gate oxide layer and the first protective electrode layer within a single vertical batch reactor. More importantly, the first protective electrode layer―the equivalent of the first polycrystalline silicon layer of the split polysilicon process of the prior art―is formed in the present invention as an amorphous silicon layer in the in situ process. The amorphous layer does not have the interstices necessary to form pathways for HF migration. As a result, the deposited amorphous silicon electrode layer will protect the gate oxide layer and can do so at a thickness substantially less than the thickness of the prior first polycrystalline silicon layer. Subsequent BiCMOS fabrication steps, including the deposition and thermal forming of the much thicker second polycrystalline silicon layer, convert the amorphous structure into the polycrystalline electrode structure needed for gate and emitter formation.

In situ processing eliminates a substantial number of the 19 steps associated with the prior batch processing needed to create the gate oxide layer and the protective first layer of electrode material. Specifically, a single vertical reactor is used to form both layers. Critical coordination of two separate reactors is no longer a problem. The steps associated with the loading of processing code and process and test wafers as well as thickness and particle measurements are cut in half. It has been determined that the number of fabrication steps involved in the formation of the novel intermediary structure of the present invention is reduced to eight.

The reduction in the number of processing steps necessarily reduces the chances for fabrication errors and/or product contamination associated with considerable wafer handling. Moreover, the processing time is reduced. The formation of an amorphous CVD silicon layer rather than a polycrystalline layer also reduces cycle time to an extent. Since the amorphous layer may be less than the prior 50 nm in thickness, the dwell time within the reactor for that stage of the cycle is reduced. However, that time savings is somewhat offset by the reduction in processing temperature required to ensure that an amorphous rather than polycrystalline silicon is formed. That temperature must be less than the 600°C level, and should be on the order of 500°-540°C.

Preliminary evaluations of the electrical characteristics of the intermediary structure formed after the deposition of the first of the two split silicon layers confirms that the thinner amorphous layer provides better protection to the gate oxide layer than available through the deposition of the thicker polysilicon layer. Those evaluations involve an analysis of the charge-to-breakdown of the gate oxide. It was further determined through that analysis that a polysilicon layer as thick as the amorphous layer of the present invention is completely ineffective in achieving desirable charge-to-breakdown characteristics.

These and other advantages of the present invention will become apparent upon review of the following detailed description, the accompanying drawings, and the appended claims.

### Brief Description of the Drawings

FIG. 1 is a flow chart of the steps associated with the prior-art formation of the gate oxide layer and the first polycrystalline silicon layer of the split polycrystalline silicon electrode.

FIG. 2 is a simplified diagrammatic elevation view of the structure resulting from the prior-art steps associated with initial sequences of the BiCMOS fabrication process, showing the buried collector layer of an NPN transistor structure and the NWell and PWell of the CMOS structure.

FIG. 3 is a simplified diagrammatic elevation view of the structure resulting from the prior-art steps associated with intermediary Mask sequences of the BiCMOS fabrication process, showing the framed field oxide regions, the buried isolation oxide layers, and the collector sink of the NPN transistor structure.

FIG. 4 is a simplified diagrammatic elevation view of the structure resulting from the new in situ sequence, showing the gate oxide layer grown on the surface of the epitaxial layer in the novel in situ process of the present invention.

FIG. 5 is a simplified diagrammatic elevation view of the structure resulting from the new in situ sequence, showing the amorphous silicon layer of a subsequent split polycrystalline silicon sequence, deposited during the in situ process of the present invention.

FIG. 6 is a flow chart of the steps associated with the formation of the gate oxide layer and the amorphous silicon layer shown in FIG. 5.

FIG. 7 is a cross-sectional view of a portion of the structure shown in FIG. 5, showing the thin oxide layer and the thicker amorphous silicon structure in a tunneling electron microscope (TEM) photograph.

FIG. 8 is a simplified diagrammatic elevation view of the structure resulting from subsequent prior-art sequences, showing the photoresist mask for implantation of the base region of the NPN transistor structure and subsequent etching away of the gate oxide layer and amorphous silicon layer of the present invention.

FIG. 9 is a simplified diagrammatic elevation view of the structure resulting from a prior-art subsequent sequence, showing the deposited polysilicon layer used to form the gates of the CMOS structure and the polysilicon emitter of the NPN transistor structure.

FIG. 10 is a cross-sectional view of a portion of the structure shown in FIG. 5, showing the thin oxide layer and both polycrystalline layers of the split polysilicon region in a tunneling electron microscope (TEM) photograph.

### Description Of The Preferred Embodiment Of The Invention

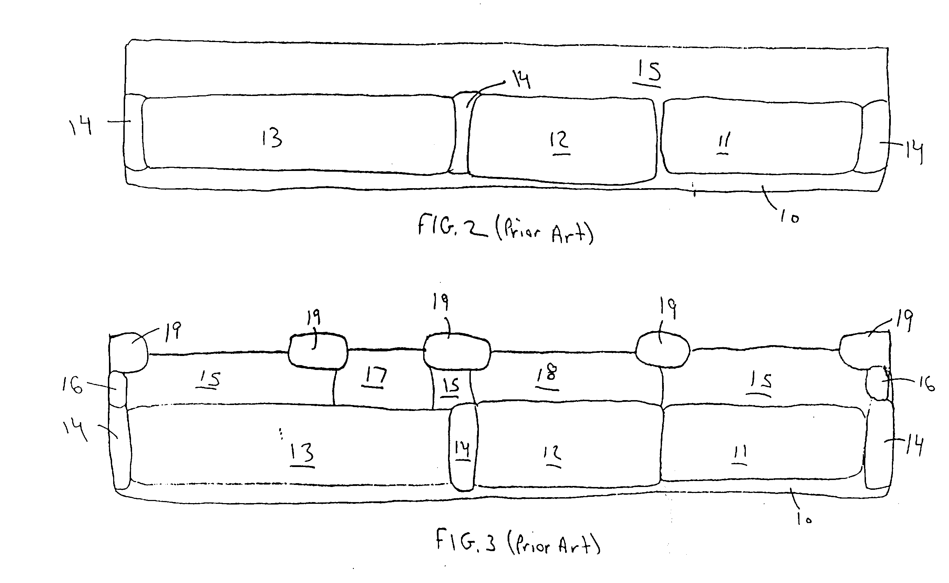

A novel method of fabricating a new intermediary BiCMOS structure of the present invention is described in conjunction with a series of fabrication steps resulting in the intermediary structures shown in FIGS. 2-7. The fabrication process used to form the structure has been integrated into the BiCMOS fabrication steps previously noted, with a significant reduction in the number of sub-steps associated with two key thermal growth stages. The overall BiCMOS transistor structure mask sequence is the sequence summarized in the Background of the Invention. While the present discussion relates to the formation of a BiCMOS structure including an NPN type bipolar transistor, it is to be understood that the process described herein may also be used in a BiCMOS fabrication process involving the formation of a PNP bipolar transistor.

Prior to the fabrication sequences used to form in situ the gate oxide and amorphous silicon protective layer of the present invention, a substrate **10** of P is used as the foundation to form the active devices. As shown in FIG. 2, a retrograde NWell region **11** for a PMOS transistor, a retrograde PWell region **12** for an NMOS transistor, and a buried collector layer **13** for an NPN bipolar transistor are formed in the substrate **10**. The NWell region **11** and the buried collector layer **13** are formed at the same time of N type atoms in an N+ concentration. Channel stop regions **14** are formed at the same time that the PWell region **12** is formed. Both are formed of P type atoms in a P+ concentration. The channel stop regions **14** are designed to isolate adjacent active structures. A single crystal epitaxial layer **15** of N⁻ silicon is then deposited uniformly over all surfaces in a blanket epitaxial deposition.

As illustrated in FIG. 3, isolation oxide regions **16** are established around the active structures above the channel stop regions **14** and near a surface of the epitaxial layer **15**. That is, the isolation oxide regions **16** diffuse to meet the channel stop regions **14**, pinching any potential channel in that location. The oxidation process causes upward diffusion of regions **11-13**. Additionally, a collector sink region **17** of relatively fast diffusing N type atoms in an N+ concentration is formed in the epitaxial layer **15** above a portion of the buried collector layer **13** for subsequent upward diffusion. The collector sink region **17** forms the basis of the electrical pathway for the collector of the NPN transistor. An implant of relatively fast diffusing P type atoms in a P concentration is formed in the epitaxial layer **15** over the PWell region **12** is used to form a P channel **18** of the NMOS transistor. Further, field oxide regions **19** for framing the active structures are formed in the surface of the epitaxial layer **15** at well-defined sites during subsequent oxidation steps. The field oxide regions **19**, which add about 100 nm to the thickness of the isolation oxide regions **16**, isolate what will become the PMOS transistor, the NMOS transistor, and the bipolar transistor from each other.

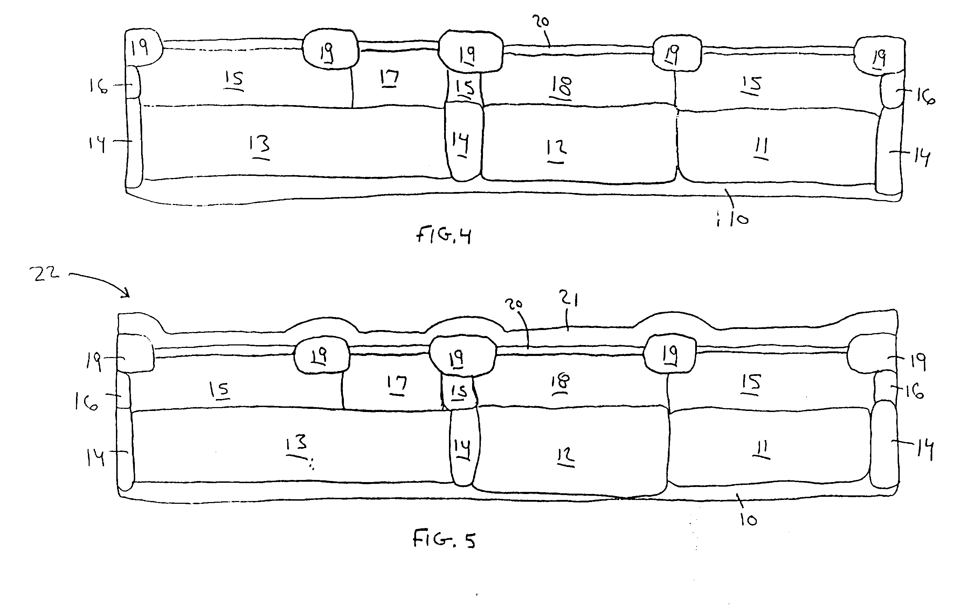

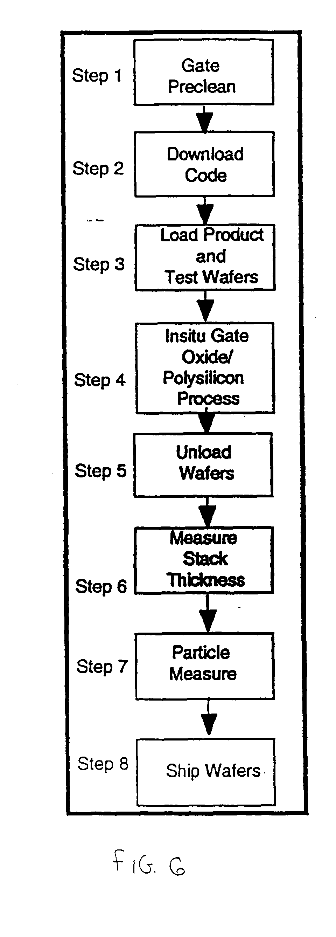

As illustrated in FIGS. 4 and 5, the process of the present invention includes the in situ steps of forming within the same vertical batch reactor a gate oxide layer **20** and a protective layer of amorphous silicon **21**. FIG., 6 presents the eight detailed steps related to the formation of those two layers, which had in the prior art, required approximately 19 steps. Initially, all surfaces of regions **15**, **17**, **18**, and **19** are pre-cleaned with a suitable wash compound. Processing codes are then loaded into the controller of the vertical batch reactor. Of course, the specific processing conditions selected will be dependent upon the specific characteristics of the active devices desired. In general terms, however, process temperature and time should be well defined.

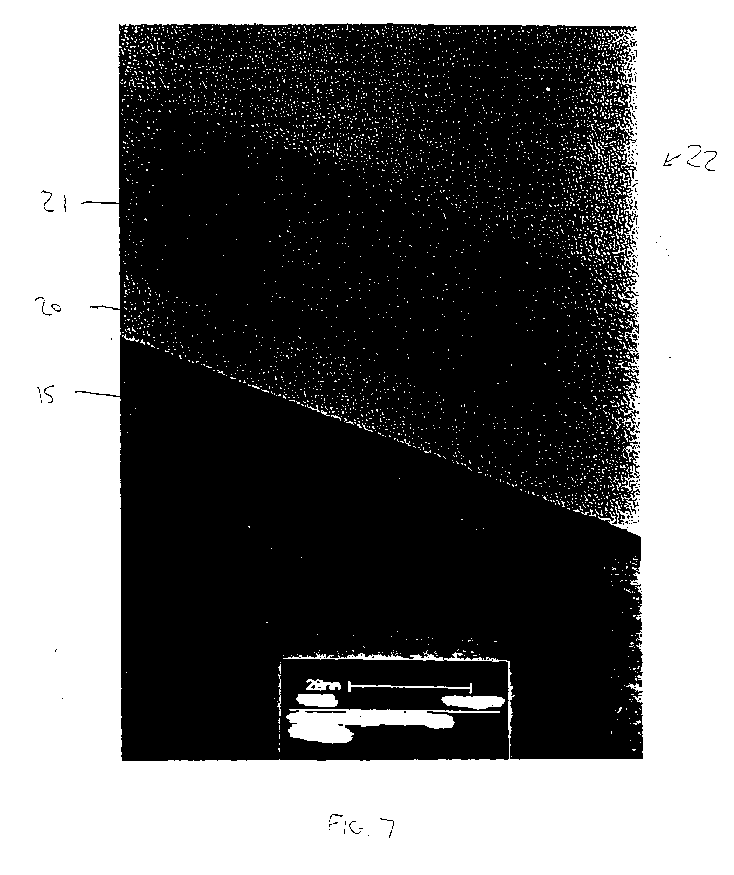

Continuing with reference to FIG. 6, product (WIP) and test wafers are loaded into the purged reactor. All wafers are then brought up to oxidation temperature in an oxygen environment. It is well known in this field the temperature and time required producing a gate oxide layer **20** of a desired thickness. In the prior art, the next step would have been to remove the WIP and test wafers from the reactor and move them to a polysilicon formation reactor. Instead, in the present invention, the reactor is purged of oxygen and the temperature lowered to one suitable for silicon deposition in a chemical vapor deposition processing using silane gas. The reaction temperature used to develop an amorphous rather than polycrystalline silicon layer is preferably about 500-550°C. This ensures that migration fields will not be formed in the protective layer **21**. Moreover, creation of the amorphous layer **21** allows for a reduction in the required thickness of that layer without effect on the integrity of the underlying oxide layer **20**. In the preferred embodiment of the present invention, layer **21** is about 30 nm thick. Prior art polysilicon protective layers had to be at least 50 nm.

Continuing with reference to FIGS. 5 and 6, a novel intermediate semiconductor structure **22** of the present invention including layers **20** and **21** formed in situ, and test wafers are removed from the reactor for thickness and particle measurements. The WIP is then transferred to another reaction site for subsequent processing. As can be seen in FIG. 7, prior to that subsequent processing, structure **22** includes over epitaxial layer **15**, for example, oxide layer **20** and protective layer **21**. Layer **21** lacks the type of interstices associated with polysilicon that would otherwise permit acid migration through to layer **20**.

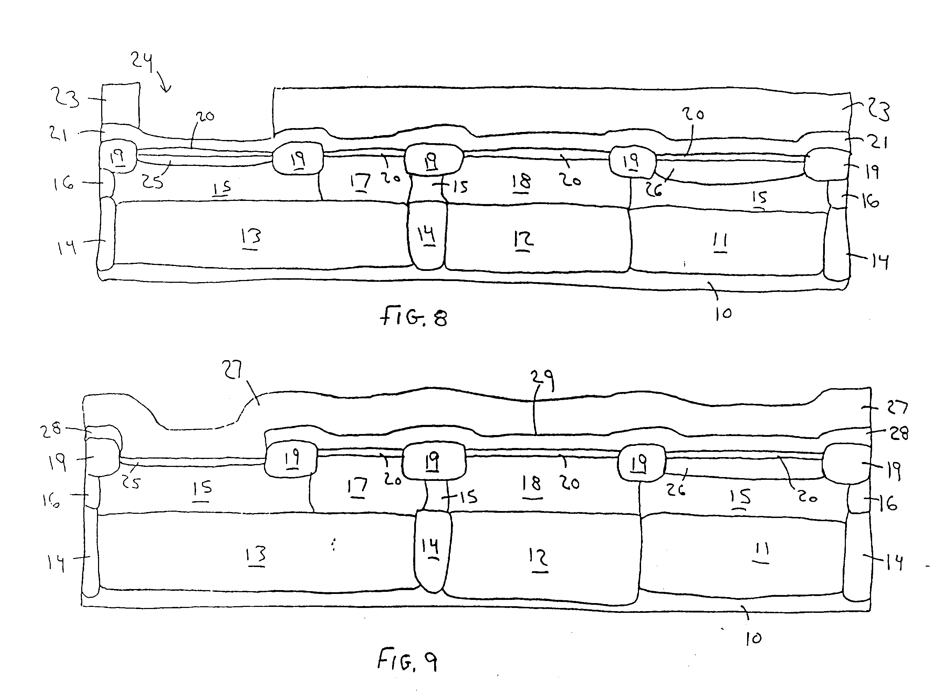

FIG. 8 illustrates one subsequent processing step related to the formation of a base region of the NPN transistor structure. Specifically, a base photoresist mask **23** includes mask opening **24** for the introduction of relatively slow diffusing P type atoms in a P++ concentration for through protective layer **21** and oxide layer **20** to form base region **25**. That same mask **23** is then used to isolate the PMOS and NMOS areas as the protective layer **21** and the oxide layer **20** are etched away over the base region **25**. This is done in preparation of later steps related to formation of the emitter region of the NPN transistor structure. Additionally, among other processing steps, region **26** is implanted in the epitaxial layer **15** over the NWell region **11** for purposes of threshold voltage adjustment and for anti-punch through control for the MOS transistors. All surfaces are then cleaned with a hydrofluoric acid wash to aid in the formation of a suitable emitter of the NPN transistor structure.

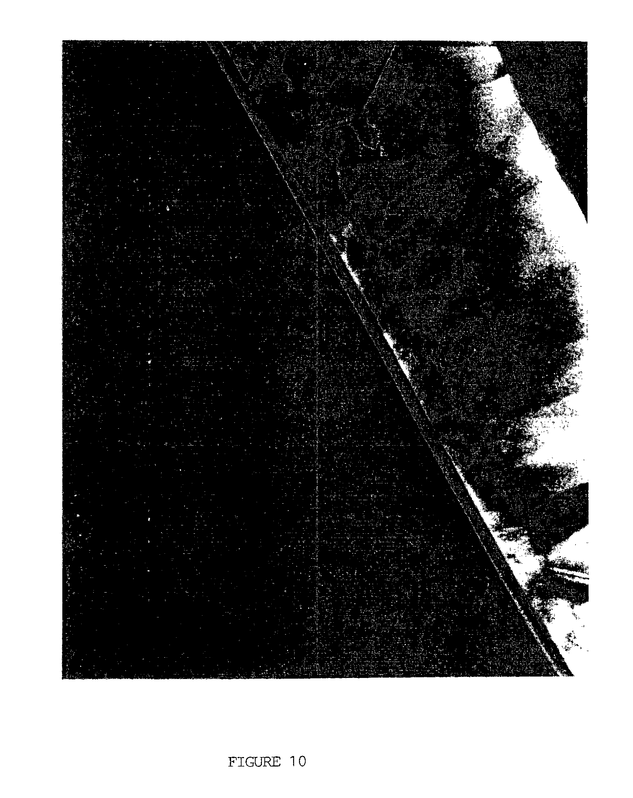

As illustrated in FIG. 9, a second silicon layer **27** is formed in a blanket chemical vapor deposition process using silane gas. The conditions used to form layer **27** in a split polysilicon process―namely temperatures in excess of 600°C―also transform amorphous silicon layer **21** into a first polysilicon layer **28** of the type necessary for following development of MOS gates and a polysilicon emitter, all suitably doped for the necessary threshold characteristics. As can be seen in FIG. 10, the two layers **27** and **28** include a polysilicon interface **29**, all of which is substantially the same as the structure associated with the prior art fabrication process at the equivalent stage of the BiCMOS process. The thickness of the combination of layers **27** and **28** is about 340 nm.

While the invention has been described with reference to particular example embodiments, it is intended to cover all modifications and equivalents within the scope of the following claims. In particular, it is to be noted that while the above detailed description includes reference to the formation of an NPN bipolar transistor, the process described would work equally as well for a PNP bipolar transistor. Further, while the detailed description relates to specific BiCMOS processing steps, it is to be understood that the in situ formation of the gate oxide layer and the amorphous silicon protective layer will work as well in the context of other BiCMOS procedures.

## Claims

1. An intermediate semiconductor structure comprising an epitaxial layer of semiconductor material of a certain conductivity type, an insulative oxide layer formed on a surface of said epitaxial layer, and a protective layer of amorphous silicon formed on a surface of said insulative oxide layer.

2. The intermediate semiconductor structure as claimed in **Claim 1** wherein said protective layer of amorphous silicon is about 30 nm thick.

3. The intermediate semiconductor structure as claimed in **Claim 2** wherein said epitaxial layer is of N type conductivity.

4. A process for fabricating an intermediate semiconductor device as part of a series of BiCMOS fabrication steps including the formation of a split polysilicon layer, the process comprising the steps of:
a. forming an epitaxial layer of semiconductor material of a certain conductivity type on a semiconductor substrate to create one or more wafers in process;
b. placing said one or more wafers in process within a reactor and introducing oxygen to said reactor to form at a first temperature an insulative oxide layer on a surface of said epitaxial layer;
c. purging said reactor of oxygen and depositing on a surface of said insulative oxide layer amorphous silicon material to form at a second temperature a protective silicon layer thereon; and
d. removing said one or more wafers in process from said reactor for transfer to subsequent BiCMOS processing stages.

5. The process as claimed in **Claim 4** wherein said first temperature is higher than said second temperature.

6. The process as claimed in **Claim 5** wherein said first temperature is about 900°C and said second temperature is about 525°C.

7. A product made by the process as claimed in **Claim 4**.

8. The process as claimed in **Claim 4** further comprising the steps of transferring said one or more wafers in process to a chemical vapor deposition reactor to form a polysilicon layer on a surface of said protective silicon layer and heating the combination of said polysilicon layer and said protective layer to a temperature sufficient to form a split polysilicon layer without amorphous polysilicon.

9. The process as claimed in **Claim 4** wherein said protective silicon layer is deposited to a thickness of about 30 nm.
